(19) Europäisches Patentamt
European Patent Office
Office européen des brevets

(11) **EP 3 435 105 B1**

(12) **EUROPÄISCHE PATENTSCHRIFT**

(45) Veröffentlichungstag und Bekanntmachung des Hinweises auf die Patenterteilung:
**03.01.2024  Patentblatt 2024/01**

(51) Internationale Patentklassifikation (IPC):
**G01R 33/483** *(2006.01)*       **G01R 33/561** *(2006.01)*
**G01R 33/56** *(2006.01)*

(21) Anmeldenummer: **17183490.6**

(22) Anmeldetag: **27.07.2017**

(52) Gemeinsame Patentklassifikation (CPC):
**G01R 33/4835; G01R 33/5611;** G01R 33/5602

(54) **VERFAHREN ZUR AUFNAHME EINES MAGNETRESONANZDATENSATZES MIT MAGNETRESONANZSIGNALEN AUS WENIGSTENS ZWEI SCHICHTEN, DATENTRÄGER SOWIE MAGNETRESONANZANLAGE**

METHOD FOR THE RECORDING OF A MAGNETIC RESONANCE DATA SET WITH MAGNETIC RESONANCE SIGNALS COMPRISING AT LEAST TWO SLICES, DATA CARRIER AND MAGNETIC RESONANCE SYSTEM

PROCÉDÉ D'ENREGISTREMENT D'UN PAQUET DE DONNÉES DE RÉSONANCE MAGNÉTIQUE À L'AIDE DE SIGNAUX DE RÉSONANCE MAGNÉTIQUE PROVENANT D'AU MOINS DEUX COUCHES, SUPPORT DE DONNÉES ET ÉQUIPEMENT DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.01.2019  Patentblatt 2019/05**

(73) Patentinhaber: **Siemens Healthcare GmbH**
**91052 Erlangen (DE)**

(72) Erfinder: **Zeller, Mario**
**91054 Erlangen (DE)**

(74) Vertreter: **Siemens Healthineers**
**Patent Attorneys**
**Siemens Healthcare GmbH**
**SHS TE IP**
**Henkestraße 127**
**91052 Erlangen (DE)**

(56) Entgegenhaltungen:
EP-A1- 0 184 840          DE-A1- 3 823 961
DE-A1-102014 204 448    DE-A1-102015 222 833

**Beschreibung**

Die Erfindung betrifft ein Verfahren zur Aufnahme eines Magnetresonanzdatensatzes mit Magnetresonanzsignalen aus wenigstens zwei Schichten.

Bei Magnetresonanzuntersuchungen muss bei spinecho-basierten Sequenzen oder einem Gradientenecho nach dem Anregen der Magnetisierung und dem Auslesen des Signals abgewartet werden, damit sich die Longitudinalmagnetisierung wieder aufbauen kann.

Bei gradientenecho-basierten Sequenzen gibt es zur Beschleunigung den Ansatz, durch Verwendung eines kleineren Anregungswinkels als 90° in einen steady state zu gelangen und dadurch die Repetitionszeit stark herabzusetzen. Derartige Sequenzen sind unter dem Namen Fast Low Angle SHot, kurz FLASH, verbreitet.

Diesen Ansatz gab es auch für die spinecho-basierte Bildgebung. Jedoch haben sich Sequenzen wie FATE oder RASEE nicht durchsetzen können, da der oder die Refokussierungsimpulse zu einem derartigen Signalverlust führen, dass die Zeitersparnis in keinem Verhältnis zum Aufwand bspw. in Form von SAR steht.

Soll ein Volumen untersucht werden, können entweder mehrere Schichten aufgenommen werden oder ein dreidimensionaler Datensatz. Bei einer Spinecho-Sequenz ist es dabei möglich, in den Wartezeiten, die nach der Aufnahme des Messsignals vorhanden sind, jeweils die anderen Schichten aufzunehmen. Die Messzeit ist dabei zwar grundsätzlich länger als bei anderen Sequenzen, es lassen sich in dieser Messzeit aber mehrere Schichten aufnehmen. Es sind maximal so viele Schichten, wie Echozeiten TE in die Repetitionszeit TR passen. Es wird also immer in einer Schicht akquiriert, während sich die Longitudinalmagnetisierung in den anderen Schichten aufbauen kann.

Die Anzahl der messbaren Schichten ist tatsächlich geringer, da vor dem Anregungsimpuls und nach dem Auslesen noch Maßnahmen wie das Anlegen von Gradienten liegen können, die durchzuführen sind, die aber bei der Berechnung der Echozeit TE nicht berücksichtigt werden.

Geht man von einer Echozeit von 30 ms aus und einer Wartezeit von 1 s nach dem Auslesen des Signals, so erhält man eine Zahl von ca. 30 Schichten, die theoretisch mittels Spinecho aufnehmbar sind, ohne die Messzeit zu erhöhen.

Eine andere Möglichkeit zur Verringerung der Messzeit ist das Verwenden mehrerer Auslesespulen. Dieses Vorgehen wird auch parallele Bildgebung genannt. Dabei wird das Messsignal mit mehreren Spulen gleichzeitig aufgenommen, wobei aber nur ein Teil der k-Raum-Zeilen aufgenommen wird. Die Signale können bei bekannten Sensitivitäten der Spulen entfaltet und dann die fehlenden k-Raum-Zeilen berechnet werden. Dieses Vorgehen ist unter dem Akronym GRAPPA bekannt.

Auch eine Entfaltung im Bildraum ist möglich.

Dabei besteht die Möglichkeit, mittels paralleler Bildgebung auch Mehrschichtmessungen parallel durchzuführen. Dies ist unter dem Namen simultaneous multislice (SMS) bekannt. Zur gleichzeitigen Anregung kann ein sogenannter Multiband-Hochfrequenzimpuls verwendet werden. Die Echosignale der einzelnen Schichten entstehen gleichzeitig und werden gleichzeitig aufgenommen. Die Separierung der Messsignale erfolgt dann zuerst schichtweise und danach innerhalb der einzelnen Schichten. Dabei ist es üblich, das Spulenarray nicht nur zu verwenden, um die Schichten separieren zu können, sondern auch, um die Bildgebung in den einzelnen Schichten zu beschleunigen.

Ein Multibandpuls kann auf folgende Weise erzeugt werden:
Ein schichtselektiver, komplexwertiger Hochfrequenzimpuls kann beschrieben werden als

$$\mathrm{RF(t)\ =\ A(t) * P(t).}$$

Dabei kann A(t) ein Standardpulsprofil sein, wobei das Schichtprofil im Zusammenspiel mit dem Schichtauswahlgradienten festgelegt wird.

P(t) ist eine Phasenmodulationsfunktion, die die Schichtposition $\Delta\omega$ und ihre Phase $\varphi$ zum Zeitpunkt TE = 0 angibt als

$$\mathrm{P(t)\ =\ exp(i\Delta\omega t + \varphi).}$$

Durch das Aufsummieren mehrerer derartiger Hochfrequenzimpulse mit unterschiedlichen Phasenmodulationsfunktionen kann ein Multiband-Hochfrequenzimpuls $\mathrm{RF_{MB}}$ erhalten werden:

$$\mathrm{RF_{MB}\ =\ A(t) * sum_N(exp(i\Delta\omega_N t + \varphi_N)).}$$

Der Laufindex bzw. die Laufvariable N bezeichnet die einzelnen Hochfrequenzimpulse. Der Multiband-Hochfrequenzimpuls ist in dieser Ausgestaltung also eine Summe von Einzelbandimpulsen.

Die aufgenommenen Messsignale müssen wie beschrieben zuerst entfaltet werden. Hierzu können entweder im Bildraum arbeitende Verfahren wie Partially Parallel Imaging With Localized Sensitivities (PILS) oder Sensitivity Encoding (SENSE) verwendet werden.

Alternativ kann die Entfaltung auch im k-Raum vorgenommen werden wie bei Simultaneous Acquisition of Spatial Harmonics (SMASH) mit den Weiterentwicklungen AUTO-SMASH und Variable Density (VD-) AUTO-SMASH oder Generalized Autocalibrating Partially Parallel Acquisitions (GRAPPA).

Das Entfaltungsverfahren wird bevorzugt zweistufig eingesetzt. Zuerst, um die Signale der unterschiedlichen Schichten zu entfalten und dann, um die Signale innerhalb der Schichten zu entfalten.

Um eine hohe Beschleunigung und ein hohes SNR zu erhalten kann bei der Datenaufnahme Multi-Slice Controlled Aliasing In Parallel Imaging Results IN Higher Acceleration (MS-CAIPIRINHA) eingesetzt werden. Bei MS-CAIPIRINHA regt ein Multiband-Hochfrequenzimpuls gleichzeitig mehrere Schichten an. Die Schichten sind voneinander getrennt und parallel angeordnet. Die Ortskodierung erfolgt für alle Schichten gleich.

Um auch ohne Verwendung eines Spulenarrays die Schichten trennen zu können wird in jeder Schicht eine schichtspezifische RF-Phase aufgeprägt. Dadurch werden die Schichten unterscheidbar und entfaltbar.

Dies ermöglicht wie beschrieben die Entfaltung gleichzeitig aufgenommener Messsignale in mehreren Schichten ohne Verwendung eines Spulenarrays. Bei Verwendung eines Spulenarrays wird die Entfaltung erleichtert und weiter verbessert.

Bei der Verwendung einer Turbo-Spin-Echo-Sequenz als bildgebendes Modul kann es dabei zu einem hohen SAR-Eintrag kommen. Dieser ist umso höher, je mehr Schichten aufgenommen werden. DE 10 2015 222833 A1 offenbart ein Verfahren zur gleichzeitigen Aufnahme von Messsignalen aus mehreren Schichten. Bei diesem werden für jede Schicht eigene Hochfrequenzimpulse verwendet und optimiert.

DE 10 2014 204 448 A1 betrifft ein Verfahren des simultaneous multi-slice imaging. Bei diesem wird in einer Schicht ein bSSFP- und in einer zweiten Schicht ein Spinecho-Kontrast oder ein T1-Kontrast erzeugt.

DE 38 23 961 A1 beschreibt ein Verfahren zur Erzeugung einer STEAM-Präparation. Das präparierte Signal wird in mehreren Schichten ausgelesen.

EP 0 184 840 A1 zeigt ebenfalls die STEAM-Präparation mehrerer Schichten, wobei das Signal zeitversetzt ausgelesen wird.

Ausgehend hiervon ist es Aufgabe der vorliegenden Erfindung, ein Verfahren zur Aufnahme eines Magnetresonanzdatensatzes anzugeben, bei dem Messsignale aus mehreren Schichten akquiriert werden und die Messzeit für einen gegebenen Umfang an Informationen minimiert ist und gleichzeitig das SAR möglichst gering ist.

Diese Aufgabe wird gelöst durch ein Verfahren zur Aufnahme eines Magnetresonanzdatensatzes mit Magnetresonanzsignalen aus wenigstens zwei Schichten mit den Schritten:

- Anlegen eines ersten Hochfrequenzimpulses in wenigstens einer ersten Schicht,
- Anlegen eines zweiten Hochfrequenzimpulses in wenigstens einer zweiten Schicht, und
- Auslesen wenigstens eines ersten Magnetresonanzsignals aus der ersten Schicht und wenigstens eines zweiten Magnetresonanzsignals aus der zweiten Schicht, wobei
- der Auslenkwinkel des zweiten Hochfrequenzimpulses kleiner ist als der Auslenkwinkel des ersten Hochfrequenzimpulses, wobei
- der erste Hochfrequenzimpuls und der zweite Hochfrequenzimpuls Teile eines Multiband-Hochfrequenzimpulses sind,

dadurch gekennzeichnet, dass

dem zweiten Hochfrequenzimpuls ein Präparationsimpuls und ein Speicherimpuls vorangestellt wird, wodurch eine STEAM-Bildgebung in der zweiten Schicht erreicht wird.

Als Kern der Erfindung wird angesehen, die Aufnahme wenigstens zweier Bilddatensätze mit unterschiedlichen Kontrasten so miteinander zu verzahnen, dass eine minimale Messzeit erhalten wird und gleichzeitig das SAR minimiert ist. Dies wird durch das Anlegen unterschiedlicher Hochfrequenzimpulse erreicht. Der Unterschied wird erzielt durch einen unterschiedlichen Auslenkwinkel. Der Auslenkwinkel eines Hochfrequenzimpulses, auch als Anregungs- oder Flipwinkel bezeichnet, gibt den Winkel an, um den die Spins aus ihrer Gleichgewichtslage durch den Hochfrequenzimpuls ausgelenkt werden.

Dabei ist der Flipwinkel des zweiten Hochfrequenzimpulses kleiner als der des ersten Hochfrequenzimpulses. Die Attribute "erster" und "zweiter" dienen dabei lediglich der Unterscheidung der Schichten und treffen keinerlei Festlegungen über die Dauer, den Zeitpunkt des Anlegens oder sonst eine Eigenschaft der Hochfrequenzimpulse.

Dabei liegen der erste und der zweite Hochfrequenzimpuls jeweils im Laufe eines Anregungszyklus mindestens einmal an. Eine Messsequenz besteht dabei aus definierten oder definierbaren Teilexperimenten. Ein Teilexperiment kann auch Anregungszyklus genannt werden. Diese Teilexperimente werden solange wiederholt, bis die benötigten Messsignale akquiriert sind.

Bei einer Spinecho-Sequenz werden bspw. so viele Anregungsimpulse angelegt wie phasenkodierende Schritte durchgeführt werden. Entsprechend gibt es so viele Anregungszyklen wie phasenkodierende Schritte.

Bei einem Turbo Spin Echo, auch Fast Spin Echo oder RARE genannt, werden mehrere Refokussierungsimpulse verwendet, weswegen von einem Echozug gesprochen wird. Bei einem Turbo Spin Echo mit 128 Phasenkodierschritten und einer Anzahl von 8 Echos in einem Echozug ergibt sich damit eine Zahl von nur 16 Anregungszyklen zur Aufnahme eines vollständigen Messdatensatzes.

Bei der Verwendung eines Spulenarrays und Auswerteverfahren der parallelen Bildgebung sinkt die Zahl der Anregungszyklen, da ein Teil der Messsignale nicht angeregt und damit auch nicht gemessen wird. Die Zahl der Anregungszyklen sinkt dann zwar um die Zahl, die sich über den Beschleunigungsfaktor ergibt. Ein Anregungszyklus ist auch bei der parallelen Bildgebung aber ein Teilexperiment, das mehrmals wiederholt wird.

Die Messsignale sind bevorzugt als Echosignal ausgestaltet.

Bei bildgebenden Experimenten werden Echosignale aufgenommen, bei spektroskopischen Experimenten und chemical shift imaging (CSI) FIDs. Erfindungsgemäß sind die Messsequenzen bildgebende Sequenzen.

Vorzugsweise werden der erste Hochfrequenzimpuls und der zweite Hochfrequenzimpuls im Laufe eines Anregungszyklus gleich oft angelegt. Dann können in einem Anregungszyklus gleich viele Messsignale in allen Schichten aufgenommen werden.

Vorteilhafterweise sind die Schichten parallel angeordnet.

Dies ist bei Mehrschichtexperimenten üblich, aber nicht zwingend. Bei der parallelen Anordnung werden Signalauslöschungen in überlappenden Bereichen vermieden.

Vorteilhafterweise werden die Messsignale mit einem Spulenarray akquiriert. Ein Spulenarray ist eine Mehrkanalspule mit mehreren Einzel-Spulen. Über die Anzahl der Spulen ist auch der Beschleunigungsfaktor bei der parallelen Bildgebung limitiert.

Dabei sind der erste Hochfrequenzimpuls und der zweite Hochfrequenzimpuls Teile eines Multiband-Hochfrequenzimpulses.

Somit liegen die Hochfrequenzimpulse gleichzeitig an. Entsprechend kann die Sequenz dem simultaneous multislice imaging zugerechnet werden.

Vorzugsweise kann jeder Schicht eine schichtspezifische RF-Phase aufgeprägt werden. Vorzugsweise können der erste Hochfrequenzimpuls und/oder der zweite Hochfrequenzimpuls die Phase aufprägen.

Wie weiter oben beschrieben, erleichtert dies die Entfaltung der Schichten bzw. ermöglicht diese erst bei Verwendung einer einzigen Empfangsspule. Dieses Vorgehen ist dann vorteilhaft, wenn mehr als ein Echo aus mehreren Schichten gleichzeitig ausgelesen wird.

Vorzugsweise kann als erster Hochfrequenzimpuls ein Refokussierungsimpuls verwendet werden. Insbesondere kann in der ersten Schicht oder den ersten Schichten eine spinecho-basierte Messsequenz verwendet werden. Der erste Hochfrequenzimpuls ist dann nicht der einzige Hochfrequenzimpuls, der in dieser Schicht angelegt wird. Als spinecho-basierte Messsequenz können insbesondere eine Spinecho- oder eine Turbo-Spin-Echo- oder eine HASTE-Sequenz verwendet werden.

Vorteilhafterweise kann als Auslenkwinkel des zweiten Hochfrequenzimpulses ein Auslenkwinkel von weniger als 70° verwendet werden. Insbesondere kann in der zweiten Schicht oder in den zweiten Schichten eine gradientenecho-basierte Messsequenz verwendet werden. Als gradientenecho-basierte Messsequenz können insbesondere eine FLASH- oder eine TrueFISP-Sequenz verwendet werden.

In der zweiten Schicht kann vorzugsweise eine steady-state-Sequenz verwendet werden. FLASH oder True-FISP sind Beispiele für steady-state-Sequenzen.

Vorzugsweise kann dem ersten Hochfrequenzimpuls ein Anregungsimpuls vorangestellt werden. Ist der erste Hochfrequenzimpuls als Refokussierungsimpuls ausgestaltet, ist dies notwendig, um ein Signal zu erhalten. Insbesondere kann der Anregungsimpuls einen Flipwinkel von 90° aufweisen.

Vorteilhafterweise kann dem ersten Hochfrequenzimpuls ein Inversionsimpuls vorangestellt werden. Dieser ist vorzugsweise auch dem Anregungsimpuls vorangestellt. Mit dieser Pulsfolge und der richtigen Wartezeit TI nach dem Inversionsimpuls kann ein FLAIR-gewichtetes Turbo-Spin-Echo zur Signalaufnahme in der oder den ersten Schichten erzeugt werden.

Dabei werden der Anregungsimpuls und der Inversionsimpuls nur in der ersten Schicht angelegt.

Es sei darauf hingewiesen, dass alle Hochfrequenzimpulse außer Multiband-Hochfrequenzimpulsen in der vorliegenden Erfindung vorzugsweise immer nur in einer Schicht angelegt werden. Andernfalls würde zum Beispiel der Inversionsimpuls nicht nur dem ersten Hochfrequenzimpuls sondern auch dem zweiten Hochfrequenzimpuls vorangestellt werden. Der erste Hochfrequenzimpuls liegt ebenfalls nur in einer Schicht an, da nur der Multiband-Hochfrequenzimpuls als Ganzes in mehreren Schichten anliegt. Die einzelnen Teile, insbesondere der erste Hochfrequenzimpuls und der zweite Hochfrequenzimpuls, liegen dagegen immer nur in einer Schicht an.

Außerdem wird dem zweiten Hochfrequenzimpuls erfindungsgemäß ein Präparationsimpuls vorangestellt. Dieser dient, wenn in der zweiten Schicht eine steady-state-Sequenz verwendet wird, der Anregung und Präparation der Magnetisierung. Er kann genauso ausgestaltet sein wie der Anregungsimpuls in der ersten Schicht, insbesondere kann sein Flipwinkel 90° sein. Er ist jedoch nicht Teil des bildgebenden Moduls der Sequenz, sondern Teil des Präparationsmoduls.

Weiterhin wird dem zweiten Hochfrequenzimpuls ein Speicherimpuls vorangestellt. Dieser folgt dem Präparationsimpuls. Mit dem Präparationsimpuls und dem Speicherimpuls wird eine STEAM-Bildgebung in der zweiten Schicht erreicht. STEAM ist das Akronym für STimulated Echo Acquisition Mode. Die Magnetisierung wird dabei nach der Anregung und ggf. Fluss- oder Diffusionspräparation in Längsrichtung gespeichert, wo sie der T1-Relaxation unterliegt. Der Speicherimpuls weist bevorzugt also auch einen Flipwinkel von 90° auf.

Dabei können mehrere erste und zweite Schichten gleichzeitig aufgenommen werden. Die Adjektive "erste" und "zweite" sollen wie beschrieben lediglich die Schichten unterscheiden helfen. Beispielsweise können fünf erste und fünf zweite Schichten gleichzeitig aufgenommen werden. Dabei können die ersten und zweiten Schichten jeweils einen Block bilden. Sie können aber auch abwechselnd angeordnet sein.

Weiterhin kann in wenigstens einer dritten Schicht ein dritter Hochfrequenzimpuls angelegt werden, dem ein Präparationsimpuls und ein Speicherimpuls vorangestellt wird, wobei der Zeitabstand zwischen dem Präparationsimpuls und dem Speicherimpuls zum dritten Hochfrequenzimpuls länger ist als der Zeitabstand zwischen dem Präparationsimpuls und dem Speicherimpuls zum zweiten Hochfrequenzimpuls. Es kann also zwei Schichten mit einer unterschiedlichen STEAM-Präparation geben.

Vorteilhafterweise können der erste und/oder der zweite Hochfrequenzimpuls in einem Anregungszyklus mehrmals angelegt werden. Es kann sich dabei wie beschrieben um die Verwendung eines Turbo-Spin-Echo und/oder einer steady-state-Sequenz handeln. Dabei ist es nicht wesentlich, ob der steady-state tatsächlich erreicht wird, sondern dass er bei Anlegen einer ausreichenden Anzahl von zweiten Hochfrequenzimpulsen erreicht würde.

Vorteilhafterweise können die Schichten wenigstens zweimal aufgenommen werden, wobei bei der zweiten Aufnahme die wenigstens eine zweite Schicht an der Position liegt, an der bei der ersten Aufnahme die wenigstens eine erste Schicht aufgenommen wurde und umgekehrt. Mit anderen Worten wird die Position der Schichten vertauscht. Der Vorteil liegt am Ende darin, an den Schichtpositionen jeweils ein Bild beispielsweise mit einem T2-gewichteten Kontrast und einem T1-gewichteten Kontrast zu haben, wobei das SAR in den einzelnen Messungen in einem mittleren Bereich gehalten werden kann.

Vorzugsweise können die Messdaten der einzelnen Schichten aus dem aufgenommenen Messdatensatz mit einem GRAPPA-Verfahren separiert werden. Wie beschrieben, müssen gleichzeitig aufgenommene Messsignale erst einzelnen Schichten zugeordnet werden.

Vorzugsweise können die Messdaten der einzelnen Schichten mit einem GRAPPA-Verfahren entfaltet werden. Dies ist bei unterabgetasteten Messdaten notwendig. Vorzugsweise können die Messdaten mit einem Spulenarray aufgenommen werden. Es kann also parallele Bildgebung zur Messdatenaufnahme verwendet werden.

Daneben betrifft die Erfindung ein Computerprogramm, umfassend Programmabschnitte, welche eine Steuerungseinrichtung zur Steuerung einer Datenerzeugungseinheit, insbesondere Bilderzeugungseinheit, einer Magnetresonanzanlage dazu veranlassen, das erfindungsgemäße Verfahren durchzuführen, wenn die Programmabschnitte auf der Steuerungseinrichtung ausgeführt werden. Bei den Programmabschnitten handelt es sich z.B. um Teile einer Messsequenz, welche eine Programmierung einer Abfolge von Hochfrequenzimpulsen, Gradientenfeldern, Akquisitionsfenstern und Wartezeiten darstellt, durch die ein Experiment zur Erzeugung von Magnetresonanzdaten definiert ist.

Ferner ist die Erfindung auf ein computerlesbares Speichermedium gerichtet, auf welchem von einer Steuerungseinrichtung zur Steuerung einer Datenerzeugungseinheit einer Magnetresonanzanlage lesbare und ausführbare Programmabschnitte gespeichert sind, welche die Steuerungseinrichtung dazu veranlassen, ein erfindungsgemäßes Verfahren auszuführen, wenn die Programmabschnitte auf der Steuerungseinrichtung ausgeführt werden. Vorteilhafterweise kann die Datenerzeugungseinheit eine Bilderzeugungseinheit sein. Beispielsweise handelt es sich bei dem computerlesbaren Speichermedium, auch Datenträger genannt, um eine Festplatte, eine Cloud, eine SD-Karte, CD-ROM, ein USB-Stick oder ein anderes digitales Speichermedium.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist.

Die Implementierung der vorgenannten Verfahren in der Steuervorrichtung kann dabei als Software oder aber auch als (fest verdrahtete) Hardware erfolgen.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:

Fig. 1      eine Magnetresonanzanlage,
Fig. 2      ein Sequenzdiagramm einer simultaneous multislice imaging-Sequenz in einer ersten Ausgestaltung,
Fig. 3      eine Anordnung von ersten und zweiten Schichten in einer ersten Ausgestaltung,
Fig. 4      eine Anordnung von ersten und zweiten Schichten in einer zweiten Ausgestaltung,
Fig. 5      ein Sequenzdiagramm einer Mehrschicht-Sequenz, die keine Multiband-Anregung beinhaltet und somit nicht in den Schutzumfang der Erfindung fällt,
Fig. 6      ein Sequenzdiagramm einer simultaneous multislice imaging-Sequenz in einer zweiten Ausgestaltung, und
Fig. 7      ein Ablaufschema eines Verfahrens zur Prozessierung von simultaneous multislice imaging-Sequenz-Messdaten.

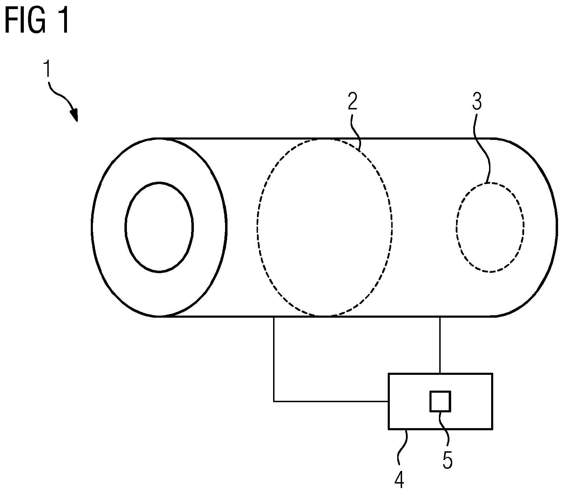

Figur 1 zeigt eine Magnetresonanzanlage 1. Diese weist eine Sendespulenanordnung 2 und eine Empfangsspulenanordnung 3 auf. Die Empfangsspulenanordnung 3 kann als Spulenarray ausgebildet sein.

Mit einer als Spulenarray ausgebildeten Empfangsspulenanordnung 3 kann die Messzeit verkürzt werden, wenn zur Rekonstruktion der unterabgetasteten Datensätze entsprechende Postprocessing-Verfahren wie PILS, GRAPPA oder SENSE verwendet werden.

Zur Steuerung der Magnetresonanzanlage 1 ist eine Steuerungseinrichtung 4 vorhanden.

Die Magnetresonanzanlage 1 besitzt weiterhin ein computerlesbares Speichermedium, insbesondere einen Datenträger 5. Der Datenträger 5 kann als Teil der Steuerungseinrichtung 4 ausgebildet sein oder unabhängig davon. Auf dem Datenträger 5 sind insbesondere Messsequenzen abgespeichert. Hierbei handelt es sich um eine zeitliche Abfolge von Hochfrequenzimpulsen, Gradientenfeldern, Akquisitionsfenstern und Wartezeiten, durch die die Messsequenz definiert ist. Durch das Aufrufen beispielsweise einer Turbo-Spin-Echo-Sequenz kann, mit oder ohne parallele Bildgebung, ein Messdatensatz mit einer Turbo-Spin-Echo-Sequenz aufgenommen werden. Diese werden von der Steuerungseinrichtung 4 geladen, um ein Experiment vorzunehmen.

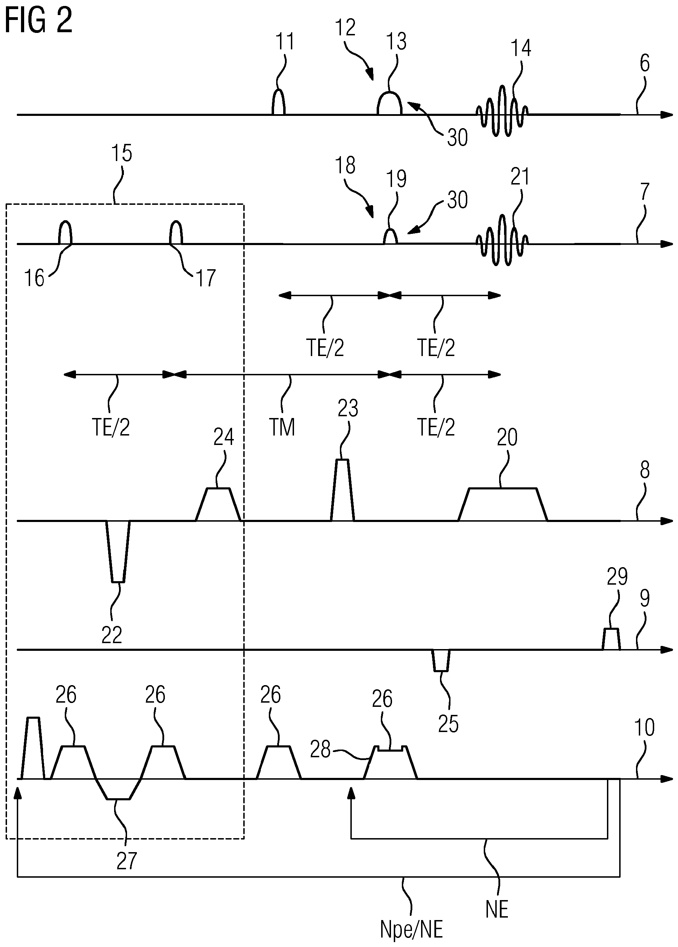

Figur 2 zeigt ein Sequenzdiagramm einer simultaneous multi-slice imaging-Sequenz. Es sind fünf Zeitachsen 6, 7, 8, 9 und 10 dargestellt, wobei der besseren Übersichtlichkeit halber die Achse, auf der die Hochfrequenzimpulse und Messsignale dargestellt sind, aufgeteilt wurde. Auf der Achse 6 sind die Hochfrequenzimpulse und Echosignale der ersten Schicht und auf der zweiten Achse 7 die Hochfrequenzimpulse und Echosignale der zweiten Schicht aufgetragen. Die Echosignale sind in der Realität natürlich nicht getrennt, sie können nur gemeinsam akquiriert werden. Es bedarf daher einer Trennungsstrategie, die z.B. in Form einer Entfaltung durchgeführt wird.

Auf der Zeitachse 8 sind die Gradienten in Leserichtung, auf der Achse 9 die Gradienten in Phasenrichtung und auf der Achse 10 die Gradienten in Schichtauswahlrichtung aufgetragen.

Mittels der in Figur 2 gezeigten Sequenz wird in der ersten Schicht ein T2-gewichtetes Turbo-Spin-Echo aufgenommen. Dementsprechend finden sich auf der Zeitachse 6 ein Anregungsimpuls 11 und als erster Hochfrequenzimpuls 12 ein Refokussierungsimpuls 13. Der Anregungsimpuls 11 hat vorzugsweise einen Flipwinkel von 90° und der Refokussierungsimpuls 13 einen Auslenkwinkel von 180°.

Diese Impulsabfolge erzeugt ein Spinecho oder allgemeiner Echosignal 14.

Durch mehrmaliges Anlegen des Refokussierungsimpulses 13 wird ein Echozug erzeugt und es können so mehrere Echosignale 14 in einem Zug aufgenommen werden. Die Anzahl der Echos bestimmt den Faktor der Beschleunigung, der im Vergleich zu einer Spinechosequenz mit einer Echoanzahl von 1 erzielt wird. Der Refokussierungsimpuls 13 wird NE-mal angelegt, wodurch NE Echos in einem Zug aufgenommen werden. NE ist dabei eine Abkürzung für "number of echoes".

Bei Turbo Spin Echo Sequenzen kann die T2-Wichtung der zentralen k-Raum-Zeilen anhand des Aufnahmeschemas festgelegt werden. Bei einem "centric" genannten Aufnahmeschema können die zentralen k-Raum-Zeilen immer in das erste Echo eines Echozuges gelegt werden. Dadurch erhält man ein höheres SNR.

Werden die k-Raum-Zeilen "linear" abgetastet, liegen die zentralen k-Raum-Zeilen in der Mitte des Echozuges, begonnen wird am einen Rand des k-Raums und geendet am anderen. Dann ist das sich ergebende Bild T2-gewichtet.

Ist das Aufnahmeschema "centric reordered" liegen die zentralen k-Raum-Zeilen um die Mitte des k-Raums herumherum, wobei in ky-Richtung immer wieder die Seiten gewechselt werden.

Der Zeitabstand zwischen dem Anregungsimpuls 11 und dem Refokussierungsimpuls 13 wie auch zwischen dem Refokussierungsimpuls 13 und dem Echosignal 14 beträgt TE/2. Die Echozeit TE gibt damit wie üblich den Zeitabstand zwischen dem Anregungsimpuls 11 und dem Echosignal 14 an.

Der Zeitabstand zwischen dem ersten Echosignal 14 und zweiten Refokussierungsimpuls 13 muss nicht TE/2 sein, dann wird auch der Abstand zwischen dem zweiten Refokussierungsimpuls 13 und dem zweiten Echosignal 14 entsprechend verändert. Ein bevorzugter Zeitabstand ist aber TE/2.

In der zweiten Schicht, und damit auf der Zeitachse 7 aufgetragen, findet sich zuerst ein Präparationsmodul 15 bestehend aus einem Präparationsimpuls 16 und einem Speicherimpuls 17. Der Präparationsimpuls 16 klappt die Magnetisierung in die Transversalebene. Der Speicherimpuls 17 klappt die Magnetisierung nach einer Zeit ES/2 wieder zurück in die Longitudinalebene. Die Magnetisierung der zweiten Schicht unterliegt damit der T1-Relaxation. Dabei kann zwischen dem Präparationsimpuls 16 und dem Speicherimpuls 17 bspw. der erste von zwei bipolaren Gradienten zur Fluss- oder Diffusionskodierung angeordnet werden. ES/2 kann genauso lang sein wie TE/2, muss es aber nicht sein. Dies ist nur dann wichtig, wenn der zweite Hochfrequenzimpuls 12 einen Flipwinkel von 90° aufweist und der Speicherimpuls 17 und der Hochfrequenzimpuls 12 zusammen ein Spinecho erzeugen. Bei der beschriebenen Ausgestaltung ist dies nicht der Fall.

Zum Auslesen des Signals der zweiten Schicht werden vorzugsweise als zweite Hochfrequenzimpulse 18 Anregungsimpulse 19 mit einem Flipwinkel kleiner als 70°, vorzugsweise kleiner als 20°, verwendet.

Werden die Anregungsimpulse 19 zu den gleichen Zeitpunkten wie die Refokussierungsimpulse 13 angelegt und die Lesegradienten 20 richtig angelegt, so entstehen die Echosignale 21 zum gleichen Zeitpunkt wie die Echosignale 14.

Auch mit der STEAM-Sequenz in der zweiten Schicht können dann NE Echosignale 21 erhalten werden.

Weiterhin kann die Sequenz einen Lese-Dephasiergradienten 22 zur Dephasierung der Magnetisierung der zweiten Schicht und einen Lese-Dephasiergradienten 23 zur Dephasierung der Magnetisierung der ersten Schicht aufweisen. Die Gradienten 22 und 23 liegen wie alle anderen Gradienten an allen Schichten an, jedoch ist zum Zeitpunkt des Anlegens des Lese-Dephasiergradienten 22 die Magnetisierung der ersten Schicht noch nicht angeregt worden, während beim Anlegen des Lese-Dephasiergradienten 23 die Magnetisierung der zweiten Schicht wieder in die Longitudinalrichtung geklappt wurde.

Die Spoilergradienten 24 dienen einer endgültigen Dephasierung und damit einer Zerstörung des Signals, während die Lese-Dephasiergradienten die Wirkung des Lesegradienten 20 vorkompensieren sollen.

Daneben werden noch Phasengradienten 25 und Schichtauswahlgradienten 26 sowie ein Schicht-Rephasiergradient 27 eingesetzt. Die Schichtauswahlgradienten 26, die parallel zu den Refokussierungsimpulsen 13 anliegen, können von Crushergradienten 28 umgeben sein. Crushergradienten 28 werden symmetrisch um Refokussierungsimpulse angeordnet und dephasieren alle Signalanteile, die nicht um 180° umgeklappt werden. Sie dienen also der Korrektur von Imperfektionen des Refokussierungsimpulses 13.

Die Phasen-Rephasierungsgradienten kompensieren die Phasengradienten 25. Sie weisen das gleiche Wirkmoment auf, nur mit umgekehrtem Vorzeichen.

Dieser in Figur 2 gezeigte Anregungszyklus wird - eine vollständige kartesische Abtastung vorausgesetzt - Npe/NE-mal durchlaufen, um ein vollständiges Bild erhalten zu können. Bei paralleler Bildgebung ist eine entsprechend verringerte Anzahl an Durchläufen ausreichend. Dabei bezeichnet Npe die Anzahl der phasenkodierenden Schritte.

Der Refokussierungsimpuls 13 und der Anregungsimpuls 19 sind als separate Impulse dargestellt. Erfindungsgemäß sind sie jedoch als

Teile eines Multiband-Hochfrequenzimpulses 30 ausgestaltet.

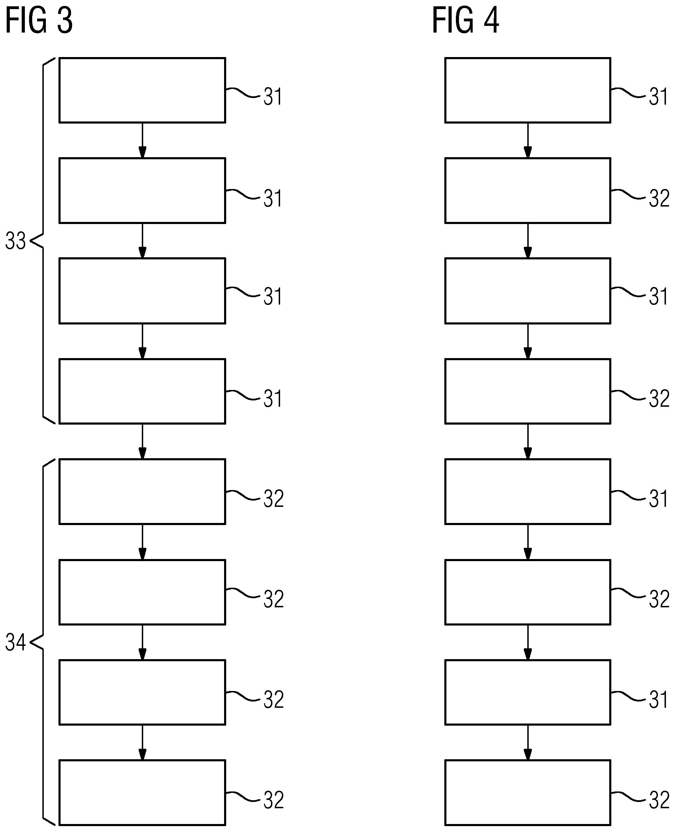

Figur 3 zeigt eine erste mögliche Anordnung von ersten Schichten 31 und zweiten Schichten 32. Wie weiter oben bereits beschrieben, sind wenigstens eine erste Schicht 31 und wenigstens eine zweite Schicht 32 vorhanden. Es können aber auch bspw. jeweils fünf erste Schichten 31 und fünf zweite Schichten 32 verwendet werden. Diese sind in Figur 3 als Block 33 und 34 angeordnet.

Eine andere Anordnung zeigt Figur 4. Hier sind die ersten Schichten 31 und zweiten Schichten 32 abwechselnd angeordnet. Bei dieser Anordnung lassen sich mögliche Crosstalk-Effekte zumindest teilweise verringern.

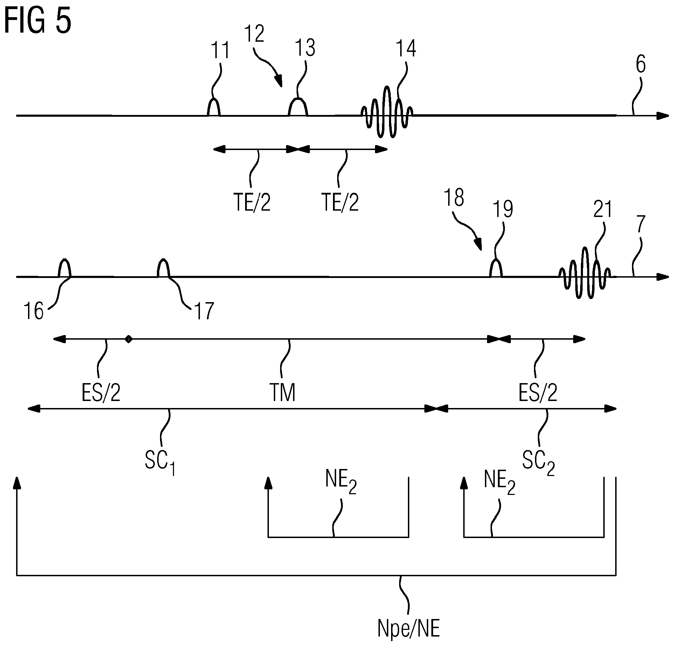

Figur 5 zeigt eine weitere mögliche Ausgestaltung einer Messsequenz 35 zum Erhalt der Echosignale 14 und 21. Dabei werden die Teilsequenzen allerdings nicht parallel ausgeführt, sondern sie sind ineinander geschachtelt. Da somit keine Multiband-Anregung durchgeführt wird, fällt die gezeigte Ausgestaltung nicht in den Schutzumfang der Erfindung.

Gleiche Bezugszeichen bezeichnen die gleichen Elemente wie in Figur 2, worauf hiermit verwiesen wird.

Bei dieser Anordnung kann die Präparationszeit TM des Präparationsmoduls 15 verlängert werden, ohne die Echozeit TE der Messung der anderen Schicht zu beeinflussen. Lange Präparationszeiten TM ergeben sich bspw. bei der Präparation von Flussgeschwindigkeiten im Bereich von 1 mm/s, bei Diffusionsmessungen oder bei bestimmten Signalkontrasten.

Auf diese Art und Weise ergeben sich zwei Abschnitte $SC_1$ und $SC_2$, wobei im ersten Abschnitt $SC_1$ die Spinechos als Echosignale 14 aufgenommen werden und im zweiten Abschnitt $SC_2$ die Echosignale 21.

Bei dieser Anordnung sind die Zeitabstände TE/2 und ES/2 völlig unabhängig voneinander.

Grundsätzlich können dabei in einem Anregungszyklus unterschiedliche Anzahlen an Echosignalen 14 bzw. 21 aufgenommen werden. Diese werden durch die Wiederholungen $NE_1$ und $NE_2$ angezeigt. Wenn in einem Anregungszyklus allerdings unterschiedliche Anzahlen an Echosignalen 14 und 21 aufgenommen werden sind am Ende der Aufnahmezeit, eine gleiche Anzahl an aufzunehmenden k-Raum-Zeilen vorausgesetzt, in der Schicht, in der bis dahin weniger k-Raum-Zeilen aufgenommen wurden, die fehlenden Zeilen noch zu akquirieren. Bei unterschiedlichen Auflösungen kann es aber gerade ein Ziel sein, eine ungleiche Anzahl aufzunehmen.

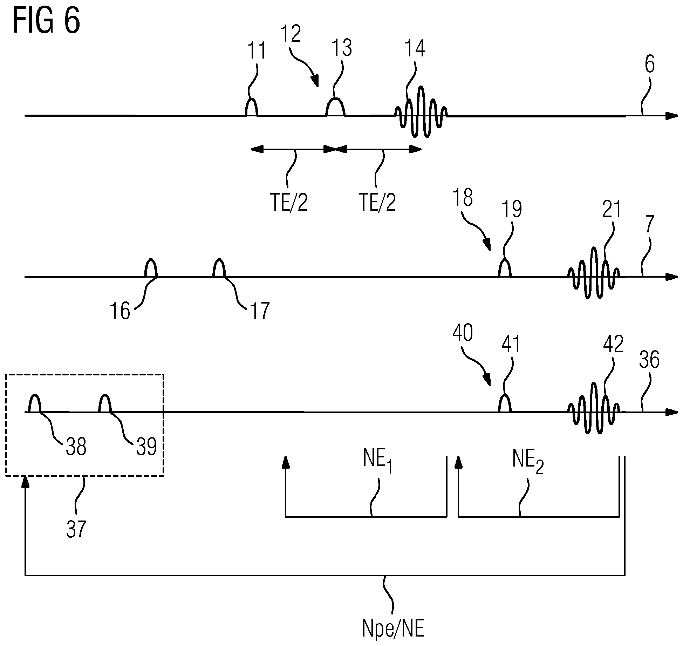

Figur 6 zeigt ein weiteres Sequenzdiagramm einer simultaneous multislice imaging-Sequenz. Dabei sind drei Zeitachsen 6, 7 und 36 dargestellt, wobei auf der Zeitachse 36 die Hochfrequenzimpulse und Akquisitionsfenster für eine dritte Schicht dargestellt sind. Dabei befindet sich zeitlich vor dem Präparationsmodul 15 ein weiteres Präparationsmodul 37 mit einem Präparationsimpuls 38 und einem Speicherimpuls 39. Der dritte Hochfrequenzimpuls 40 in Form des Anregungsimpulses 41 wird zeitgleich zum zweiten Hochfrequenzimpuls 18 angelegt.

Bis auf den Zeitabstand des Präparationsmoduls 37 zum Anregungsimpuls 38 sind dabei die Pulsfolgen auf den Zeitachsen 7 und 37 identisch. Das Echosignal 42 der dritten Schicht wird also gleichzeitig zu den anderen Echosignalen 14 und 21 aufgenommen.

Die Gradienten-Zeitachsen 8 und 9 entsprechen denen in Figur 2, in Schichtauswahlrichtung liegen die Gradienten des Präparationsmoduls 15 auch beim Präparationsmodul 37 an.

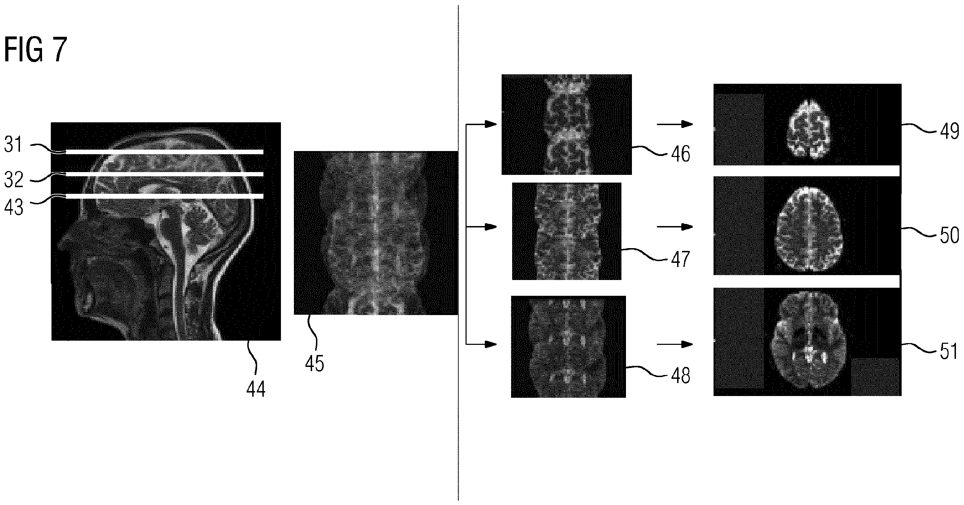

Figur 7 zeigt einen Ablauf zur Aufnahme und Prozessierung eines simulaneous multislice imaging-Datensatzes. Dabei werden anfangs drei Schichten 31, 32 und 43 in einem Übersichtsdatensatz 44 festgelegt. Nach der Aufnahme der Messsignale zum Beispiel mit der in Figur 6 gezeigten Messsequenz hat man eine Messdatensatz 45, in dem Messsignale aus den drei Schichten 31, 32 und 43 enthalten sind. Nicht gezeigt ist dabei, dass die Echosignale 14, 21 und 42 eine aufgeprägte Phase enthalten, also z.B. MS-CAIPIRINHA-präpariert sind.

Die Messsignale 14, 21 und 42 können durch ein Entfaltungsverfahren wie GRAPPA in die einzelnen Messdaten 46, 47 und 48 separiert werden. Da diese unterabgetastet sind wird innerhalb der Schichten nochmals das GRAPPA-Verfahren angewendet, um die entfalteten Bilddaten 49, 50 und 51 zu erhalten.

## Patentansprüche

1. Verfahren zur Aufnahme eines Magnetresonanzdatensatzes (38) mit Magnetresonanzsignalen (14, 21) aus wenigstens zwei Schichten (31, 32, 37) mit den Schritten:

   - Anlegen eines ersten Hochfrequenzimpulses (12) in wenigstens einer ersten Schicht (31),
   - Anlegen eines zweiten Hochfrequenzimpulses (18) in wenigstens einer zweiten Schicht (32), und
   - Auslesen wenigstens eines ersten Magnetresonanzsignals aus der ersten Schicht (31) und wenigstens eines zweiten Magnetresonanzsignals aus der zweiten Schicht (32), wobei
   - der Auslenkwinkel des zweiten Hochfrequenzimpulses (18) kleiner ist als der Auslenkwinkel des ersten Hochfrequenzimpulses (12), wobei
   - der erste Hochfrequenzimpuls (12) und der zweite Hochfrequenzimpuls (18) Teile eines Multiband-Hochfrequenzimpulses (30) sind,

   **dadurch gekennzeichnet, dass**

   - dem zweiten Hochfrequenzimpuls (18) ein Präparationsimpuls (16) und ein Speicherimpuls (17) vorangestellt wird, wodurch eine STEAM-Bildgebung in der zweiten Schicht erreicht wird.

2. Verfahren nach Anspruch 1, **dadurch gekennzeichnet, dass** als erster Hochfrequenzimpuls (12) ein Refokussierungsimpuls (13) verwendet wird, und dass dem ersten Hochfrequenzimpuls (12) ein Anregungsimpuls (11) vorangestellt wird.

3. Verfahren nach einem der vorangehenden Ansprüche, **dadurch gekennzeichnet, dass** als Auslenkwinkel des zweiten Hochfrequenzimpulses (18) ein Auslenkwinkel von weniger als 70° verwendet wird.

4. Verfahren nach einem der vorhergehenden Ansprüche, **dadurch gekennzeichnet, dass** dem ersten Hochfrequenzimpuls (12) ein Inversionsimpuls vorangestellt wird.

5. Verfahren nach einem der vorangehenden Ansprüche, **dadurch gekennzeichnet, dass** in einer dritten Schicht (43) ein dritter Hochfrequenzimpuls (40) angelegt wird, dem ein Präparationsimpuls (38) und ein Speicherimpuls (39) vorangestellt wird, wobei der Zeitabstand zwischen dem Präparationsimpuls (38) und dem Speicherimpuls (39) zum dritten Hochfrequenzimpuls (40) länger ist als der Zeitabstand zwischen dem Präparationsimpuls (16) und dem Speicherimpuls (17) zum zweiten Hochfrequenzimpuls (18).

6. Verfahren nach einem der vorhergehenden Ansprüche, **dadurch gekennzeichnet, dass** der erste Hochfrequenzimpuls (12) und/oder der zweite Hochfrequenzimpuls (18) in einem Teilexperiment mehrmals angelegt werden.

7. Verfahren nach einem der vorhergehenden Ansprüche, **dadurch gekennzeichnet, dass** die Schichten (31, 32, 43) wenigstens zweimal aufgenommen werden, wobei bei der zweiten Aufnahme Positionen der wenigstens einen ersten Schicht (31) und der wenigstens einen zweiten Schicht (32) vertauscht sind.

8. Computerprogramm, umfassend Programmabschnitte, welche eine Steuerungseinrichtung (4) zur Steuerung einer Datenerzeugungseinheit, insbesondere Bilderzeugungseinheit, einer Magnetresonanzanlage (1) dazu veranlassen, ein Verfahren nach einem der Ansprüche 1 bis 7 auszuführen, wenn die Programmabschnitte auf der Steuerungseinrichtung (4) ausgeführt werden.

9. Computerlesbares Speichermedium (5), auf welchem von einer Steuerungseinrichtung (4) zur Steuerung einer Datenerzeugungseinheit einer Magnetresonanzanlage (1) lesbare und ausführbare Programmabschnitte gespeichert sind, welche die Steuerungseinrichtung (4) dazu veranlassen, ein Verfahren nach einem der Ansprüche 1 bis 7 auszuführen, wenn die Programmabschnitte auf der Steuerungseinrichtung (4) ausgeführt werden.

10. Magnetresonanzanlage (1) mit einer Steuerungseinrichtung (4), **dadurch gekennzeichnet, dass** die Steuerungseinrichtung (4) zur Durchführung eines Verfahrens nach einem der Ansprüche 1 bis 7 konfiguriert ist.

## Claims

1. Method for recording a magnetic resonance data set (38) with magnetic resonance signals (14, 21) from at least two slices (31, 32, 37) comprising the steps:

   - application of a first radio-frequency pulse (12) in at least one first slice (31),
   - application of a second radio-frequency pulse (18) in at least one second slice (32), and
   - read-out of at least one first magnetic resonance signal from the first slice (31) and at least one second magnetic resonance signal from the second slice (32), wherein
   - the deflection angle of the second radio-frequency pulse (18) is smaller than the deflection angle of the first radio-frequency pulse (12), wherein
   - the first radio-frequency pulse (12) and the second radio-frequency pulse (18) are parts of a multiband-radio-frequency pulse (30),

   **characterised in that**

   - the second radio-frequency pulse (18) is preceded by a preparation pulse (16) and a storage pulse (17), whereby a STEAM imaging in the second slice is achieved.

2. Method according to claim 1, **characterised in that** a refocusing pulse (13) is used as a first radio-frequency pulse (12), and the first radio-frequency pulse (12) is preceded by an excitation pulse (11).

3. Method according to one of the preceding claims, **characterised in that** a deflection angle of less than 70° is used as a deflection angle of the second radio-frequency pulse (18) .

4. Method according to one of the preceding claims, **characterised in that** the first radio-frequency pulse (12) is preceded by an inversion pulse.

5. Method according to one of the preceding claims, **characterised in that** in a third slice (43) a third radio-frequency pulse (40) is applied which is preceded by a preparation pulse (38) and/or a storage pulse (39), wherein the interval between the preparation pulse (38) and the storage pulse (39) with respect to the third radio-frequency pulse (40) is longer than the interval between the preparation pulse (16) and the storage pulse (17) with respect to the second radio-frequency pulse (18).

6. Method according to one of the preceding claims, **characterised in that** the first radio-frequency pulse (12) and/or the second radio-frequency pulse (18) are applied several times in a partial experiment.

7. Method according to one of the preceding claims, **characterised in that** the slices (31, 32, 43) are recorded at least twice, wherein the positions of the at least one first slice (31) and the at least one second slice (32) are reversed in the second recording.

8. Computer program comprising program sections which trigger a control device (4) for controlling a data generation unit, in particular an image generation unit, of a magnetic resonance system (1) to execute a method according to one of claims 1 to 7 when the program sections are executed on the control device (4).

9. Computer-readable storage medium (5) on which readable and executable program sections of a control device (4) for controlling a data generation unit of a magnetic resonance system (1) are stored which prompt the control device (4) to perform a method according to one of claims 1 to 7 when the program sections are executed on the control device (4).

10. Magnetic resonance system (1) having a control device (4), **characterised in that** the control device (4) for the execution of a method is configured according to one of claims 1 to 7.

**Revendications**

1. Procédé d'enregistrement d'un ensemble (38) de données de résonnance magnétique par des signaux (14, 21) de résonnance magnétique provenant de deux couches (31, 32, 37) comprenant les stades :

   - application d'une première impulsion (12) en haute fréquence à au moins une première couche (31),
   - application d'une deuxième impulsion (18) en haute fréquence à au moins une deuxième couche (32), et
   - lecture d'un premier signal de résonnance magnétique provenant de la première couche (31) et d'au moins un deuxième signal de résonnance magnétique provenant de la deuxième couche (32), dans lequel
   - l'angle de déflection de la deuxième impulsion (18) en haute fréquence est plus petit que l'angle de déflection de la première impulsion (12) en haute fréquence, dans lequel
   - la première impulsion (12) en haute fréquence et la deuxième impulsion (18) en haute fréquence font partie d'une impulsion (30) en haute fréquence multibande,

   **caractérisé en ce que**

   - une impulsion (16) de préparation et une impulsion (17) d'accumulation précèdent la deuxième impulsion (18) en haute fréquence, grâce à quoi on obtient une imagerie STEAM dans la deuxième couche.

2. Procédé suivant la revendication 1, **caractérisé en ce que** l'on utilise, comme première impulsion (12) en haute fréquence, une impulsion (13) de refocalisation, et **en ce qu'**une impulsion (11) d'excitation précède la première impulsion (12) en haute fréquence.

3. Procédé suivant l'une des revendications précédentes, **caractérisé en ce que** l'on utilise, comme angle de déflection de la deuxième impulsion (18) de haute fréquence, un angle de déflection de moins de 70°.

4. Procédé suivant l'une des revendications précédentes, **caractérisé en ce qu'**une impulsion d'inversion précède la première impulsion (12) en haute fréquence.

5. Procédé suivant l'une des revendications précédentes, **caractérisé en ce que**, dans un troisième stade (43), on applique une troisième impulsion (40) en haute fréquence que précède une impulsion (38) de préparation et une impulsion (39) d'accumulation, dans lequel la distance dans le temps entre l'impulsion (38) de préparation et l'impulsion (39) d'accumulation à la troisième impulsion (40) en haute fréquence est plus grande que la distance dans le temps entre l'impulsion (16) de préparation et l'impulsion (17) d'accumulation à la deuxième impulsion (18) en haute fréquence.

6. Procédé suivant l'une des revendications précédentes, **caractérisé en ce que** l'on applique plusieurs fois dans une expérience partielle la première impulsion (12) en haute fréquence et/ou la deuxième impulsion (18) en haute fréquence.

7. Procédé suivant l'une des revendications précédentes, **caractérisé en ce que** l'on enregistre au moins deux fois les couches (31, 32, 43), dans lequel, lors du deuxième enregistrement, on échange des positions de la au moins une première couche (31) et de la au moins une deuxième couche (32).

8. Programme d'ordinateur, comprenant des parties de programme, qui font qu'un dispositif (4) de commande d'une unité de production de données, notamment une unité de production d'image d'une installation (1) à résonnance magnétique, effectue un procédé suivant l'une des revendications 1 à 7, lorsque les parties de programme sont exécutées sur le dispositif (4) de commande.

9. Support (5) de mémoire, déchiffrable par ordinateur, sur lequel sont mises en mémoire des parties de programme pouvant être lues et exécutées par un dispositif (4) de commande d'une unité de production de données d'une installation (1) à résonnance magnétique, qui font que le dispositif (4) de commande effectue un procédé suivant l'une des revendications 1 à 7, lorsque les parties de programme sont exécutées sur le dispositif (4) de commande.

10. Installation (1) à résonnance magnétique comprenant un dispositif (4) de commande, **caractérisée en ce que** le dispositif (4) de commande est configuré pour effectuer un procédé suivant l'une des revendications 1 à 7.

FIG 1

# FIG 2

EP 3 435 105 B1

FIG 3

31

31

31

31

33

32

32

32

34

32

FIG 4

31

32

31

32

31

32

31

32

14

FIG 5

FIG 6

11 12 13 14 6

TE/2 TE/2

18 19 21 7

16 17

40 41 42 36

38 39

37

$NE_1$ $NE_2$

Npe/NE

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102015222833 A1
- DE 102014204448 A1
- DE 3823961 A1
- EP 0184840 A1